(19) Europäisches Patentamt / European Patent Office / Office européen des brevets

(11) **EP 1 795 907 A1**

(12) **EUROPEAN PATENT APPLICATION**

(43) Date of publication:
**13.06.2007 Bulletin 2007/24**

(51) Int Cl.:
***G01R 19/25*** (2006.01)  ***G01R 27/16*** (2006.01)
***G01R 31/42*** (2006.01)

(21) Application number: **06022189.2**

(22) Date of filing: **24.10.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **25.11.2005 IT TO20050834**

(71) Applicant: **RAI RADIOTELEVISIONE ITALIANA S.p.A.**
**00195 Roma (IT)**

(72) Inventors:
• **La Rosa, Mario**
**00168 Roma (IT)**
• **Sacco, Bruno**
**10154 Torino (IT)**

(74) Representative: **Spandonari, Carlo**
**Spandonari & Modiano s.r.l.**
**corso Duca degli Abruzzi 16**
**10129 Torino (IT)**

(54) **An impulsive impedance meter for electric power systems**

(57)     The impedance meter measures the harmonics of the output impedance of a power system by connecting to its terminals a load comprising a resistive portion (20, 21) and a portion comprising an active filter (22) driven by a waveshape generator (24). A digital computer (32) controls the active filter so that it will draw a current (Itest) having a triangular waveshape, and reads from a voltmeter (28) successive time samples first of no-load voltage (v1), then of voltage under load (vN), and reads from an ammeter (30) samples of current under load (vaN) during one period of the waveshape of the current. The computer then calculates impedance values (zN) for successive harmonics by dividing the terms of the Fourier transform of the differences between said samples of voltage under load (vN) and said samples of no-load voltage (v1) by the corresponding terms of the Fourier transform of said samples of current under load (aN).

Fig. 2

EP 1 795 907 A1

**Description**

This invention is concerned with an impulsive impedance meter for measuring the spectral distribution of the output impedance of the electric AC power supply mains, either single-phase or three-phase.

An electric power distribution network should provide the user with an alternate sinusoidal voltage, at a constant frequency, so that its output impedance has a single, constant value. However, mainly due to distorting noises which may be introduced to the network when a user connects a complex load, but also due to other causes including internal anomalies in the network, the voltage or current wave often turns out to be deformed from its nominal sinusoidal shape, with generation of harmonics. Depending on how the user employs the electric power, such harmonics may sometimes give rise to operation problems in the systems being supplied, which are themselves complex or nonlinear, e.g. including filters, electronic switches, and the like.

The above circumstances can give rise to a number of different shortcomings, such as poor overall efficiency of the system, untimely opening of fuses, mechanical vibration and flicker of light sources, etc. In particular, such shortcomings compel the designer to oversize machines, switching devices and power cables, to protect the neutral wire from overcurrents, to equip both power and signal networks with special shields and filters. Designing the above defensive devices involves, however, having a knowledge of the characteristics of the supply delivered from the mains, i.e., in substance, the output impedance of the mains as a function of frequency.

It is the main object of the invention to provide an impedance meter for pulse-measuring the spectral distribution of the output impedance of an electric AC power supply network, either single-phase or three-phase.

It another object to provide the above impedance meter so that it does not cause appreciable noise in the network.

The above object is attained by the invention, together with other objects and advantages such as will appear from the following disclosure, by providing an impedance meter having the features recited in claim 1.

The dependent claims point out further advantageous features of the invention.

A preferred embodiment of the invention is described below, with reference to the attached drawings, wherein:

Fig. 1 is a general circuit diagram illustrating the problem of the invention;

Fig. 2 is a block diagram of an impedance meter according to a preferred embodiment of the invention;

Figs. 3 and 4 together comprise a flowchart of the operation of the impedance meter of Fig. 2.

For the sake of simplicity, the invention will be explained with reference to a single-phase, a.c. electrical supply, although the invention is readily applicable to a three-phase supply, by merely duplicating the illustrated circuits for each of the three phases.

The measurement of the values of the equivalent network impedance at the different harmonics is based, according to the invention, on the principle of circulating through the mains a current wave train having a waveshape rich in harmonics, e.g. a triangle waveshape, at a rate equal to the fundamental frequency of the mains current, and in monitoring both the current and the voltage at the mains during the wave train, the performance of the network during the applied wave train being then derived by computation. Finally, by correlation with the starting waveshape, the spectral distribution of the equivalent mains impedance is obtained. Advantageously, the wave train is obtained by modulating the current drawn by an adjustable complex load according to the desired waveshape, as described below.

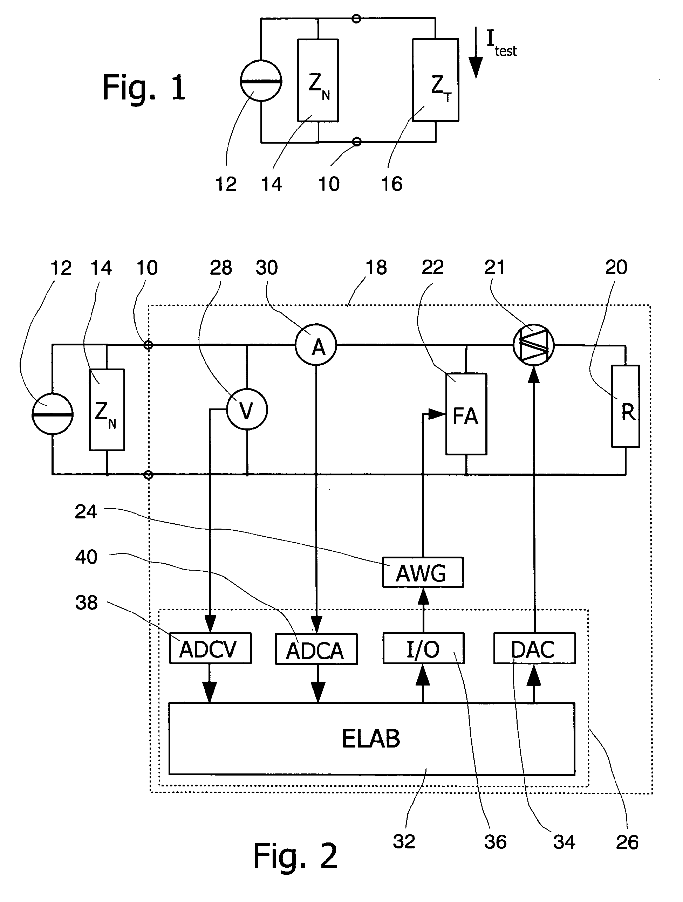

In Fig. 1, a single-phase, AC electrical supply network, e.g. at 380 V, 50 Hz, is represented by an equivalent circuit across the mains 10, which comprises a sinusoidal AC current generator 12 and a shunt-connected impedance 14 having a value Z. Impedance Z represents not only the internal impedance of the network operator's power generation plant, but also the impedances of the loads which are connected to the network by the users, and which are in parallel with one another. Consequently, the value Z is potentially liable to variations, i.e. it can float over time as the users connect loads to or or disconnect loads from the network. Moreover, although the impedance Z should ideally be regarded as frequency-independent, in practice the equivalent impedance of a real network is in general a function of frequency, i.e. it has different values at the fundamental frequency and at its successive harmonics.

With further reference to Fig. 1, a test load 16 of value $Z_T$ is connected to the mains 10. According to the invention, both the absolute value and the phase of $Z_T$ are modulated so that they draw desired harmonic currents in an interval coinciding with a period of the fundamental frequency of the network, e.g. for a network at 50 Hz, and interval of 20 msec (although an interval of a few periods may also be adopted, say for instance a 100 msec). This is equivalent to circulate a current waveshape Itest(t) in the network, such as a triangular waveshape.

If $I_R$ is a current generated by source 12 and $Z_R$ is the mains impedance, a first measure of the voltage $V_o$ across $Z_T$ at instant O, i.e. while $I_{test} = O$ must be:

$$V_0 = Z_R I_R \tag{1}$$

When performing a second measure with $I_{test} \neq 0$, the voltage $V_t$ at an instant t must be:

$$V_t = Z_R (I_R + I_{test}). \tag{2}$$

It will initially be assumed that $Z_R$ does not change from one measure to the next, i.e. in practice that no appreciable loads or sources are connected to or disconnected from the network, such that the equivalent impedance of the network may change across the mains 10.

By combining (1) and (2) it is obtained:

$$Z_R = (V_t - V_0) / I_{test} \tag{3}$$

With reference to Fig. 2, an impedance meter according to the invention, referenced generally as 18, essentially comprises a resistive load 20 having a predetermined, fixed value R, which is series-connected to a TRIAC 21, and to which an active filter or active harmonic compensator 22 is connected in parallel. Active filter 22 is driven by a waveshape generator or AWG 24. Both the TRIAC 21 and the AWG 24 are controlled by control means 26 described below.

The active filter 22, known per se, is capable of drawing currents at programmable frequencies, and is preferably of a type based on switched capacitors, as described, for instance, in Mohan, Undeland, Robbins, Power Electronics, Wiley, 1995; or in P. N. Enjeti, W. Shiren, P. Packebush, I. Pitel, "Analysis and Design of a new Active Power Filter to Cancel Neutral Current harmonics in Three-phase Four-wire Electric Distribution Systems", IEE Trans. Ind. Applic., vol. 30 no. 6, Dec 1994; or in M. Mc Granaghan, L. Tang, S Bernard, S. Papoz, "Evaluation of Active Filter Design and Performance Using a Detailed EMTP Model", PQA 95, May 1995.

Active filters of this kind are marketed, for instance, by MGE Italia SpA, at Agrate Brianza, under the trade name "Filtro attivo THM" or "SineWave THM".

Impedance meter 18 comprises a voltmeter 28 and an ammeter 30, which are connected for measuring the instantaneous voltage V across terminals 10 and the instantaneous current entering the group 20, 21, 22, and for delivering respective voltage and current signals to the above mentioned control means 26, which will compute the network impedance as described below.

Control means 26 essentially comprise a digital computer 32, which is equipped with several interface cards, as follows:

- a digital-analog conversion card 34 (DAC) driving TRIAC 21;

- an I/O port 36 for driving the waveshape generator 24, so that a desired waveshape is generated;

- a first data-acquisition card 38 (ADCV), driven by voltmeter 28 and designed to sample the measured instantaneous voltage, convert the samples to a digital form, and deliver the samples to computer 32;

- a second data-acquisition card 40 (ADCA), driven by ammeter 30 and designed to sample the measured instantaneous current, convert the samples to a digital form, and deliver the samples to computer 32.

The operation of the apparatus of Fig. 2 will now be described, and more particularly the algorithm carried out by computer 32 in order to determine the spectral distribution of the impedance of the network.

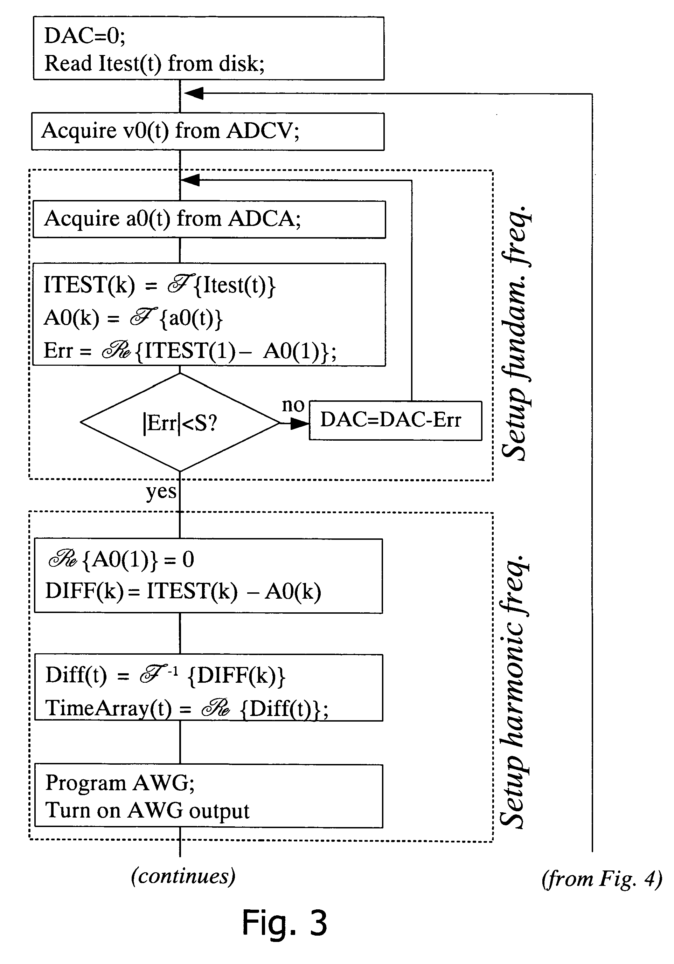

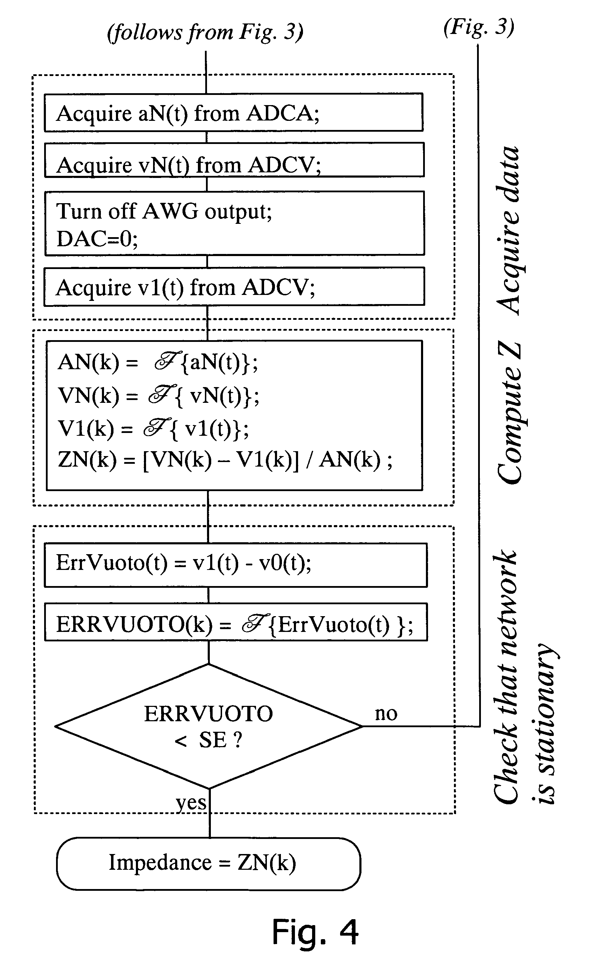

With reference to the flowchart of Fig. 3, when the apparatus is started, computer 32 will initially reset the DAC converter 34 and will read, e.g. from a disk, a table $I_{test}(t)$, representing the current values desired at successive instants t = 0, 1, 2, ..., n of a single period of the AC voltage at 50 Hz, i.e. of 20 msec.

At an instant coinciding with a zero of the AC supply voltage, determined by the trigger signal issued by voltmeter 28, the computer starts a set-up routine for the fundamental frequency, by which it acquires from ammeter 30 a sequence of measured current values a(t) corresponding to the above mentioned values Itest(t), over a single period of the supply voltage.

Computer 32 then proceeds to compute the discrete Fourier transforms:

$$ITEST(k) = \mathscr{F}\{Itest(t)\}$$

$$A(k) = \mathscr{F}\{a(t)\}$$

where k = 1, 2, ..., m, for the fundamental, the second harmonic, etc., respectively.

The computer then derives an error value Err consisting of the real part of the difference ITEST(i) - A(1), i.e. the difference of the current components at the fundamental frequency. It will be understood that, if Err is zero (in practice, if its absolute value is less than a suitably chosen threshold S), that means that TRIAC 21 is regulating resistance 20 to its appropriate value, i.e. a value coinciding with the desired consumption of active power, while a nonzero value of the error can be used to adjust the conduction angle of the TRIAC so that the effective value of the resistance becomes closer to the ideal value. Consequently, the computer, after comparing the error with threshold S, modifies resistance 20 (DAC = DAC - Err) and cyclically repeats the measuring and computing steps as mentioned above, until the absolute value of the error |Err| is reduced to zero, i.e., in practice, until it is has decreased below the said threshold S. At this point, resistance 20 has the proper value corresponding to the active power drawn by the required complex load at the fundamental frequency.

After exiting the set-up routine for the fundamental frequency, the program sets to zero the real part of A(1), which does not concern the measure of distortion in the network, and computes, for each harmonic, the difference:

$$DIFF(k) = ITEST(k) - A(k)$$

and then reverts to the time domain by computing the inverse transform:

$$Diff(t) = \mathscr{F}^{-1}\{DIFF(k)\}$$

The real part of Diff(t), TimeArray(t) = $\mathscr{Re}$ {Diff(t)}, represents an error waveshape which must be absorbed by the active filter 22. A person skilled in the art will understand that an active filter so driven injects into the line, at each period of the 50-Hz AC voltage, a current that will supplement the current through resistance 20, so that the total current will have a shape corresponding to the desired curve, thereby simulating a desired overall load. Therefore, waveshape generator 24 is programmed so that active filter 22 delivers this result.

The value of the fixed resistance 20 is chosen for a power level corresponding to the maximum power level for which the apparatus is designed.

It should of course be noted that TRIAC 21 of Fig. 2, beside changing the value of the fundamental current, also generates spurious harmonics which are superposed onto the variantions of the current. However, as a person skilled in the art will readily appreciate, the successive steps in the flowchart of Fig. 3 also automatically keep track of these harmonics, which contribute to the values a(t) and therefore participate to calculating the transforms and inverse transforms, and consequently to building the current waveshape drawn by active filter 22.

When the preliminary set-up steps for the several frequencies have thus been completed, the program acquires the measured current and voltage samples aN(t) and vN(t). Moreover, after clearing the outputs of waveshape generator 24 and DAC 34, the program acquires the voltage samples v1(t) corresponding to equation (1), i.e. it again performs a measurement identical to the first measurement vo(t) which it had performed at the start of the cycle, for reasons explained below.

In the subsequent step, the program calculates the equivalent network impedance components according to equation (3), i.e. as the ratio of the difference of the voltages vN and v1 under load to the current aN drawn by the load. The ratio must be calculated for each individual frequency, i.e. the fundamental, the second harmonic, the third harmonic, etc. Consequently, the program computes the discrete Fourier transform of the two data tables aN(t) and vN(t) and v1(t), thereby obtaining AN(k), VN(k) and V1(k), with k = 1, 2, 3, ..., and then computes the ratio ZN(k) = [VN(k) - V1(k)] / AN(k), which is the spectral distribution of the network impedance, at the fundamental frequency, at the second harmonic, at the third harmonic, etc., respectively.

It should further be noted, as warned above, that the output impedance of the network at the mains 10 is also determined, sometimes substantially, by the user loads that are connected to and disconnected from the network at random intervals. These appear as sometimes complex loads that are shumnt-connected to the rest of the network, and can change its behavior both in its active and in its reactive components, and influencing not only the fundamental frequency, but also the harmonics. If the equivalent network impedance should be so changed during the execution of the above described procedure, the measurement would be misrepresented.

Consequently, the invention provides that the program performs a comparison in order to check that there has been no appreciable changes in the network (such as connections or disconnections of distorting loads) during the executed procedure, though short, i.e. that the no-load voltage v1(t) during the measurement period is still substantially equal to the values vo(t) measured at the start of the cycle. To this purpose, the program is designed to calculate ErrVuoto (t) as a difference of the new measured values v1(t) minus the initial values vo(t), and to transform that error value to ERRVUOTO(t) in the frequency domain, i.e. to the error values for the individual harmonics, and then to compare this table fo values with a threshold SE, which may be a uniform value for all harmonics, but preferably is itself a table of distinct values for the individual harmonics.

If the error is below the threshold, that means that the network has not changed significantly during the measurment, and the cycle may then be completed by assuming the derived ZN(k) as a reliable measure of the equivalent network impedance. In the opposite case, ZN(k) should be considered as a misrepresentation, and the program then reverts to the start, in order to repeat the entire procedure.

The execution of the load modulation algorithm is easily programmable for a person skilled in the art, based on the flowchart of Figs. 3 and 4. Persons skilled in the art will also readily implement the impedance meter for three-phase loads, both in the delta and the Y connection, by mere duplication of the circuits described for single-phase loads for each of the three phases.

It should be noted that, although the TRIAC-regulated, fixed resistance is the preferred implementation, the adjustable resistive load could also be a rheostat controlled by a step motor, or even a stack of resistances that are manually adjustable by an operator, under the direction of an error indication supplied by the computer. In special applications, the impedance meter could even use a fixed resistor, without any provision for adjustment: in this case, the set-up step for the fundamental frequency in the flowchart of Fig. 3 would be dispensed with, although the set-up for the harmonic frequencies would still be carried out. In the latter case, the initial set-up step at the fundamental frequency would be eliminated, and even the set-up for the harmonic frequencies could be simplified.

Obviously, the above described procedure can be repeated at regular intervals, say every minute, for monitoring purposes, and in that case the above described program is easy to be made a part of a timed loop, e.g. in order to execute and record the measurement every few minutes.

**Claims**

1. An impedance meter for the impulsive measurement of the output impedance harmonics of an electric AC power supply network, **characterized in that** it comprises:

   - a resistive load (20, 21) connected to the terminals (10) of the network via an ammeter (30);
   - an active filter (22) connected in parallel to said resistive load and driven by a waveshape generator (24);
   - a voltmeter (28) for measuring the the voltage across the network terminals (10);
   - control means (26) interfaced with the waveshape generator (24), with the voltmeter (28) and with the ammeter (30), and programmed for executing the following basic cycle of steps:

      a) driving said waveshape generator (24), after connecting the resistive load, so that the active filter draws a current (Itest) having a predefined waveshape comprising several harmonic components of the fundamental network frequency;
      b) reading successive time samples of the voltage under load (vN) and current under load (aN) from said voltmeter (28) and ammeter (30), respectively, during one period of said predefined waveshape;
      c) reading form the voltmeter (28) successive time samples of the no-load voltage (V1) while the resistive load (R) and the active filter (FA) are not drawing current;
      d) calculating impedance values (zN) for successive harmonics of the network frequency, by dividing the terms of the Fourier transforms of the differneces of said samples of voltage under load (vN) minus said samples of no-load voltage (V1) by the corresponding terms of the Fourier transform of said samples of current under load (aN).

**2.** The impedance meter of claim 1, **characterized in that** said control means (26) are also interfaced with said resistive load (20, 21) to dynamically adjust its effective value, and **in that** the control means (26) are programmed to perform a set-up routine before the basic cycle of steps.

**3.** The impedance meter of claim 2, **characterized in that** said set-up routine the following steps:

    e) reading from the ammeter (30) time samples of no-load current (ao) while the resistive load (R) and the active filter (FA) are disconnected from the network;
    f) adjusting the effective value of the resistive load so that the active component of the Fourier transform of the no-load current measured at the fundamental frequency ($\mathscr{R}_e$ {Ao(1)}) is substantially zero;
    g) determining the deviation of the spectrum of the test current (ITEST) from the spectrum of the measured no-load current (Ao), with exclusion of said active current component at the fundamental frequency, and programming said waveshape generator (24) so that the active filter generates a waveshape corresponding to the inverse Fourier transform of said spectrum deviation (DIFF).

**4.** The impedance meter of claim 3, **characterized in that**, in order to determine the deviation (DIFF) of the spectrum of the test current (ITEST) from the spectrum of the measured current (AN), with exclusion of said active current component at the fundamental frequency, the control means (26) calculate the difference between the discrete Fourier transforms of the test current and the current measured after setting at zero the real component of the latter at the fundamental frequency, calculate the inverse discrete Fourier trasform of said last-mentioned difference, and program the waveshape generator (24) with said inverse transform.

**5.** The impedance meter of claim 2, 3 or 4, **characterized in that** said adjustable resistive load comprises a fixed resistor (20) and a series-connected controlled switch (21), and **in that** the control means (26) are interfaced with the controlled switch to adjust its conductiona angle via a digital-to-analog converter (34).

**6.** The impedance meter of claim 5, **characterized in that** said controlled switch is a TRIAC (21).

**7.** The impedance meter of claim 4 or 5, **characterized in that**, in order to determine the value of the active current corresponding to the the component of the current at the fundamental frequency as measured with no load (ao), the control means (26) calculate the discrete Fourier transforms (ITEST(k), Ao(k)) both of the desired current and of the measured current, calculate the difference between their components at the fundamental frequency (Err) and adjust the value of said adjustable load until said difference is substantially canceled.

**8.** The impedance meter of any of claims 3 to 7, **characterized in that** said control means (26) are further programmed for reading, before the basic cycle of operations, samples of no-load voltage (vo) across the mains (10) while the active filter is turned off and the resistive load is disconnected, and for comparing, after the basic cycle of operations, the samples of no-load voltage (v1) obtained from step c) with the corresponding said samples (vo) in order to check whether they are substantially equal, and for repeating the entire cycle of operations in the opposite case.

**9.** The impedance meter of any of claims 1 to 8, **characterized in that** said control means (26) comprise a digital computer (32) having communication interfaces (34, 36, 38, 40) with said resistive load (20, 21), said waveshape generator (24), said voltmeter (28) and said ammeter (30), respectively.

Fig. 1

12   14   10   16

Fig. 2

DAC=0;
Read Itest(t) from disk;

Acquire v0(t) from ADCV;

Acquire a0(t) from ADCA;

ITEST(k) = $\mathscr{F}${Itest(t)}
A0(k) = $\mathscr{F}${a0(t)}
Err = $\mathscr{Re}${ITEST(1) − A0(1)};

|Err|<S?

no → DAC=DAC-Err

yes

$\mathscr{Re}${A0(1)} = 0
DIFF(k) = ITEST(k) − A0(k)

Diff(t) = $\mathscr{F}^{-1}${DIFF(k)}
TimeArray(t) = $\mathscr{Re}${Diff(t)};

Program AWG;
Turn on AWG output

*Setup fundam. freq.*

*Setup harmonic freq.*

*(continues)*

*(from Fig. 4)*

# Fig. 3

*(follows from Fig. 3)*     *(Fig. 3)*

Acquire aN(t) from ADCA;

Acquire vN(t) from ADCV;

Turn off AWG output;
DAC=0;

Acquire v1(t) from ADCV;

$AN(k) = \mathscr{F}\{aN(t)\};$

$VN(k) = \mathscr{F}\{vN(t)\};$

$V1(k) = \mathscr{F}\{v1(t)\};$

$ZN(k) = [VN(k) - V1(k)] / AN(k) ;$

ErrVuoto(t) = v1(t) - v0(t);

$ERRVUOTO(k) = \mathscr{F}\{ErrVuoto(t)\};$

ERRVUOTO
< SE ?

no

yes

Impedance = ZN(k)

*Acquire data*

*Compute Z*

*Check that network
is stationary*

## Fig. 4

European Patent
Office

**EUROPEAN SEARCH REPORT**

Application Number

EP 06 02 2189

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 587 662 A1 (KELLEY ARTHUR W [US] ET AL) 24 December 1996 (1996-12-24) * abstract * * column 3, line 55 - column 4, line 5; claims 1,7; figure 1 * | 1,9 | INV. G01R19/25 G01R27/16 G01R31/42 |
| A | | 2-8 | |
| | ----- | | |
| X | JASON P RHODE ET AL: "Complete Characterization of Utilization-Voltage Power System Impedance Using Wideband Measurement" IEEE TRANSACTIONS ON INDUSTRY APPLICATIONS, IEEE SERVICE CENTER, PISCATAWAY, NJ, US, vol. 33, no. 6, December 1997 (1997-12), XP011022305 ISSN: 0093-9994 * page 1472, column 1, line 16 - page 1473, column 2, line 36; figure 1 * * page 1473, column 1, line 42 - column 2, line 44 * | 1-9 | |
| | ----- | | TECHNICAL FIELDS SEARCHED (IPC) |
| A | WO 00/10017 A (UNIV ALBERTA [CA]) 24 February 2000 (2000-02-24) * abstract; figures 7,8 * | 1-9 | G01R |
| | ----- | | |

The present search report has been drawn up for all claims

| Place of search | Date of completion of the search | Examiner |
|---|---|---|
| Berlin | 22 March 2007 | Binger, Bernard |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

........................................................................
& : member of the same patent family, corresponding
   document

EPO FORM 1503 03.82 (P04C01)

**ANNEX TO THE EUROPEAN SEARCH REPORT
ON EUROPEAN PATENT APPLICATION NO.**                    EP 06 02 2189

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2007

| Patent document cited in search report | | Publication date | Patent family member(s) | Publication date |
|---|---|---|---|---|
| US 5587662 | A1 | | NONE | |
| WO 0010017 | A | 24-02-2000 | US 6182017 B1 | 30-01-2001 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MOHAN ; UNDELAND ; ROBBINS.** Power Electronics. Wiley, 1995
- **P. N. ENJETI ; W. SHIREN ; P. PACKEBUSH ; I. PITEL.** Analysis and Design of a new Active Power Filter to Cancel Neutral Current harmonics in Three-phase Four-wire Electric Distribution Systems. *IEE Trans. Ind. Applic.,* December 1994, vol. 30 (6

- **M. MC GRANAGHAN ; L. TANG ; S BERNARD ; S. PAPOZ.** Evaluation of Active Filter Design and Performance Using a Detailed EMTP Model. *PQA 95,* May 1995